# EUROPEAN PATENT APPLICATION

(11) **EP 2 421 150 A1**
(43) Date of publication of application: **22.02.2012**
(21) Application number: 11166583.2
(22) Date of filing: 18.05.2011
(51) Int. Cl.: H03G 3/30

(54) **Gain control device and gain control method**

(30) Priority: 19.08.2010 JP 2010184224
(71) Applicant: Kabushiki Kaisha Toshiba, Tokyo 105-8001 (JP)
(72) Inventor: Iwata, Shigeyasu, Tokyo (JP)
(74) Representative: Henkel, Breuer & Partner

(57) **Abstract**

According to one embodiment, a gain control device comprises a noise detector (12) and a gain controller (14). The noise detector (14) is configured to detect a noise level of a variable gain amplifier. The gain controller (16) is configured to control a gain of the variable gain amplifier based on the noise level detected by the noise detector.

## Description

Embodiments described herein relate generally to a gain control device of a variable gain amplifier and a gain control method thereof.

In a conventional general variable gain amplifier, an input signal is input to the inverting input terminal of an operational amplifier via an input resistor R1. An output signal is input to the inverting input terminal via a feedback resistor R2. The non-inverting input terminal is grounded. The gain of such a variable gain amplifier is determined by the resistance ratio if the open loop gain of the operational amplifier is sufficiently large. It is therefore possible to implement a desired gain by adjusting the resistances.

Electronic circuits recently tend to be formed as an integrated circuit, and accordingly, recent variable gain amplifiers are also often formed as an integrated circuit. For example, a variable gain amplifier to be used in the infrared signal processing circuit of a remote control receiver or the like is desired to be an integrated circuit to reduce cost and power consumption. The absolute value of a resistance in an integrated circuit varies considerably (for example, about 10%) between products. However, when elements are made large, and the resistors R1 and R2 are arranged close on the circuit board, their absolute values vary to almost the same degree. Hence, the ratio (relative variation) remains almost constant. For this reason, the gain of the variable gain amplifier does not vary so greatly between products. Such a variable gain amplifier may be suitable for integration. However, a prerequisite needs to be that the operational amplifier has a sufficiently large open loop gain.

Various problems of analog circuits are recently coming to the surface, including a drop of the power supply voltage and an increase in variations between products caused by device microfabrication, resulting in difficulty in ensuring a sufficient open loop gain. Hence, the open loop gain of the variable gain amplifier cannot be sufficiently large, and as a result, the gain cannot be determined only by the resistance ratio. For this reason, the gain of the variable gain amplifier may greatly shift from the desired one because it is impossible to ensure a sufficient gain for the variable gain amplifier due to the influence of, for example, manufacturing variations and fluctuations in temperature and power supply voltage. For example, a gain of 100 dB is wanted for use in an infrared receiver. In fact, the gain varies by about ±20 dB.

Since the conventional variable gain amplifier cannot make the open loop gain sufficiently large because of gain variations between products, the gain cannot be determined only by the resistance ratio, and a desired gain is difficult to implement.

A general architecture that implements the various features of the embodiments will now be described with reference to the drawings. The drawings and the associated descriptions are provided to illustrate the embodiments and not to limit the scope of the invention.
FIG. 1 is an exemplary block diagram showing an example of the arrangement of a gain control device of a variable gain amplifier according to the first embodiment.
FIG. 2 is an exemplary block diagram showing an example of the arrangement of a gain control device of a variable gain amplifier according to the second embodiment.
FIG. 3 is an exemplary block diagram showing an example of the arrangement of a gain control device of a variable gain amplifier according to the third embodiment.
FIG. 4 is an exemplary block diagram showing an example of the arrangement of an infrared signal processing device according to the fourth embodiment.

Various embodiments will be described hereinafter with reference to the accompanying drawings. In general, according to one embodiment, a gain control device comprises a noise detector and a gain controller. The noise detector is configured to detect a noise level of a variable gain amplifier. The gain controller is configured to control a gain of the variable gain amplifier based on the noise level detected by the noise detector.

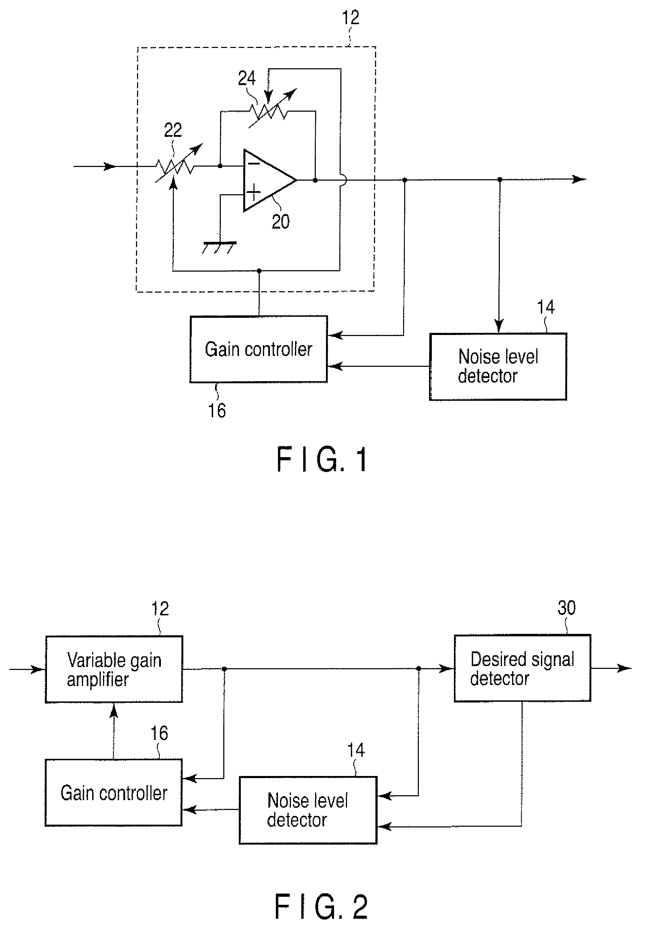

FIG. 1 illustrates the arrangement of a gain control device of a variable gain amplifier according to the first embodiment. The gain control device comprises a variable gain amplifier 12, and a noise level detector 14 and a gain controller 16 which are connected to the output terminal of the variable gain amplifier 12. The output from the noise level detector 14 is input to the gain controller 16.

The variable gain amplifier 12 comprises an operational amplifier 20, an input resistor 22, and a feedback resistor 24. The variable gain amplifier 12 is implemented by, for example, an inverting amplification circuit. An input signal is input to the inverting input terminal of the operational amplifier 20 via the input resistor 22. The output signal from the operational amplifier 20 is input to the inverting input terminal via the feedback resistor 24. The non-inverting input terminal is grounded (or fixed to a predetermined voltage). Both the input resistor 22 and the feedback resistor 24 are variable resistors whose resistances change based on a gain control signal from the gain controller 16. It is possible to change and adjust the gain of the variable gain amplifier 12 to a desired gain by adjusting resistances of the resistors 22 and 24. The variable gain amplifier 12 is designed such that the range of gain change caused by changes in the resistances comprises (desired gain range) ± (gain variation). For example, if it is known in advance that the desired gain ranges from 0 to 100 dB, and the variation is ±10 dB, resistances of the resistors 22 and 24 are set so as to change the gain from -10 to 110 dB. Note that the variable gain amplifier 12 may be implemented by a non-inverting amplification circuit or a differential amplification circuit.

The noise level detector 14 detects the continuous noise level contained in the output of the variable gain amplifier 12. The noise level detector 14 is implemented by, for example, a low pass filter. The cutoff frequency of the low pass filter is set to be sufficiently low, for example, several Hz so as to detect (pass) only noise without detecting the level of a desired signal as the amplification target to be input to the variable gain amplifier 12. To set a sufficiently low cutoff frequency for the low pass filter, the time constant is designed to be large. Hence, the noise level detector 14 rarely reacts to the desired signal that is the amplification target having a certain frequency component but gradually increases the output value upon receiving noise. Even in a no signal state without external input, the variable gain amplifier 12 generates and outputs noise (for example, white noise and flicker noise) from the elements such as transistors and resistors. When converted into the input signal, the noise is also amplified. For this reason, the continuous noise level contained in the output of the variable gain amplifier 12 depends on the gain. Hence, detecting the noise level in the output of the variable gain amplifier 12 is almost equivalent to detecting the gain of the variable gain amplifier 12. If the detected noise level is high, the gain can be determined to vary toward the high side. If the noise level is low, the gain can be determined to vary toward the low side. Note that when an external signal is output to the variable gain amplifier 12, noise is likewise superimposed on a signal and output.

The gain controller 16 outputs a gain control signal for changing resistances of the resistors 22 and 24 to control the gain of the variable gain amplifier 12 in accordance with the output of the variable gain amplifier 12 and the output of the noise level detector 14. The gain controller 16 controls the gain of the variable gain amplifier 12 such that the output level of the desired signal amplified by the variable gain amplifier 12 becomes a first predetermined level, and the output level of the noise level detector 14 becomes a second predetermined level as well.

The gain control method of the gain control device will be described next. Even when resistances of the resistors 22 and 24 are set to predetermined values, the variable gain amplifier 12 may be unable to implement the desired gain due to variations between products. If the desired gain ranges from 0 to 100 dB, and the variation is ±10 dB, as described above, the range of gain change by the resistors 22 and 24 is set from -10 to 110 dB so as to compensate for the gain variations.

Resistances of the resistors 22 and 24 are initially set to obtain a gain of 100 dB. However, the actual gain of the variable gain amplifier 12 is 90 to 110 dB because of the variations between products. If the gain decreases to 100 dB or less in the initial state without input of the desired signal, the noise level also decreases, as described above. Hence, the noise level detector 14 detects the decreased noise level, and the gain controller 16 outputs a gain control signal to increase the gain and raise the noise level to the second predetermined level. Conversely, if the gain increases to 100 dB or more in the initial state, the noise level also rises. The noise level detector 14 detects the higher noise level, and the gain controller 16 outputs a gain control signal to decrease the gain and decrease the noise level to the second predetermined level.

Note that when continuous noise is externally input, gain control is done by detecting the noise level including the externally input noise. Hence, stable operation is possible even if external noise is input.

Even when the desired signal is input to the variable gain amplifier 12, the gain controller 16 controls the gain of the variable gain amplifier 12 in the same way in accordance with its output level such that the output level of the desired signal amplified by the variable gain amplifier 12 becomes the first predetermined level. During the period the desired signal is input to the variable gain amplifier 12, the output of the noise level detector 14 gradually decreases because it does not detect the desired signal. However, since the time constant of the noise level detector 14 is large, the change is much smaller than the change in the desired signal. For this reason, during the variable gain amplifier 12 outputs the desired signal, the gain controller 16 controls the gain in accordance with not the output of the noise level detector 14 but only the output of the variable gain amplifier 12. For example, when a desired signal having a large amplitude is input to the variable gain amplifier 12, and the output level of the variable gain amplifier 12 is the first predetermined level or more, the gain controller 16 decreases the gain so as to decrease the output level of the variable gain amplifier 12 to the first predetermined level. After that, when the input of the desired signal stops, and the variable gain amplifier 12 outputs only noise, the noise level also decreases to the second predetermined level or less because the gain is decreased.

Accordingly, the gain controller 16 increases the gain so as to raise the output noise level of the variable gain amplifier 12 to the second predetermined level. Note that since the time constant of the noise level detector 14 is large, and its output slowly changes, the gain of the variable gain amplifier 12 also slowly increases.

As described above, the actual gain of the variable gain amplifier 12 is detected based on the noise level, and the gain is controlled based on the actual gain. Hence, even when the gain of the variable gain amplifier 12 shifts from a desired gain, the output level of the variable gain amplifier 12 can be set to a desired level. Even when the open loop gain of the operational amplifier included in the variable gain amplifier 12 cannot be ensured sufficiently, the gain error of the variable gain amplifier 12 can be corrected.

A conventional typical gain control device does not comprise the noise level detector 14. This device merely detects the amplitude of the output signal of the amplifier and controls the gain such that the output signal has a desired value. However, assume that the gain varies to 90 dB in the negative direction, and the signal input to the amplifier is very small. If the gain is 100 dB, the amplitude of the output signal for the very small signal is detectable. However, the amplifier cannot sufficiently amplify the signal by the gain of 90 dB, the amplitude of the output signal may be undetectable. In this case, the gain control device cannot grasp the decrease in the gain, and therefore does not control to increase the gain. For this reason, the circuit on the succeeding stage of the variable gain amplifier cannot detect the signal. In this embodiment, however, the gain of the variable gain amplifier is detected based on the noise level, and the gain is controlled based on this. It is therefore possible to appropriately adjust the gain even if the output signal level is very low.

Conversely, if the gain varies in the positive direction, more noise than necessary may be generated to cause operation errors in the circuit of the succeeding stage. According to this embodiment, it is possible to prevent such operation errors.

According to this embodiment, there are provided a gain control device of a variable gain amplifier and a gain control method thereof, which can implement a desired gain without being affected by gain variations between products.

Note that the noise level and the signal level are detected at the output of the variable gain amplifier 12. However, these levels may be detected at any other portion. For example, a band pass filter may be connected to the output of the variable gain amplifier 12 to detect the noise level and the signal level at the output of the band pass filter. The amplitude may easily be detected via the band pass filter.

Other embodiments will be described below. The same reference numerals as in the first embodiment denote the same parts in the description of the other embodiments, and a detailed description thereof will be omitted.

FIG. 2 shows the arrangement of a gain control device of a variable gain amplifier according to the second embodiment. The second embodiment is different from the first embodiment in that a desired signal detector 30 is connected to the output terminal of the variable gain amplifier 12.

As described above, the noise level detector 14 comprising a low pass filter detects only a continuous noise level. The cutoff frequency needs to be set sufficiently low to avoid the influence of a desired signal. To lower the cutoff frequency, the time constant needs to be large. This makes the resistances and capacitances larger, resulting in a larger circuit scale.

To prevent this, in the second embodiment, the desired signal detector 30 is provided to determine whether the desired signal is input to the variable gain amplifier 12. The operation of the noise level detector 14 is on/off controlled based on the determination result. That is, when the desired signal is detected, input to the noise level detector 14 is cut to turn off (stop) its operation. The low pass filter included in the noise level detector 14 has a large time constant. For this reason, if the operation off period is short, the noise level detection value is directly held. When the input period of the desired signal is predetermined several milliseconds as in case of application to a remote control receiver, the output level of the noise level detector 14 is sufficiently held. The noise level detector 14 can comprise a level holding capacitor as needed. When detection of the desired signal stops, the operation of the noise level detector 14 is turned on (resumed). The desired signal detector 30 can comprise, for example, a band pass filter for extracting the desired signal and a level detector.

According to the second embodiment, since the desired signal is not input to the noise level detector 14, the time constant of the low pass filter included in the noise level detector 14 need not be large. Hence, the effect of implementing a device with a small circuit scale can be obtained in addition to the functions and effects of the first embodiment.

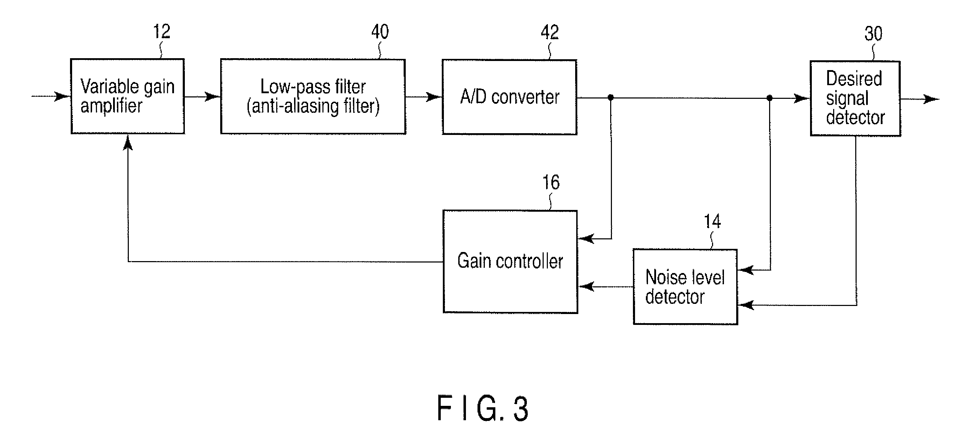

FIG. 3 shows the arrangement of a gain control device of a variable gain amplifier according to the third embodiment. The third embodiment is different from the second embodiment in that a low pass (anti-aliasing) filter 40 and an analog-to-digital (A/D) converter 42 are connected between the variable gain amplifier 12 and the desired signal detector 30. This realizes the processes of the noise level detector 14, the gain controller 16, and the desired signal detector 30 digitally.

According to the third embodiment, the effect of facilitating the processes of the noise level detector 14, gain controller 16, and desired signal detector 30 digitally can be obtained in addition to the functions and effects of the second embodiment. If the desired signal is an infrared remote control signal, the desired signal detector 30 can detect the desired signal only by detecting its preamble (leader signal) or the like. The noise level detector 14 can hold the detection operation only by setting the signal disable.

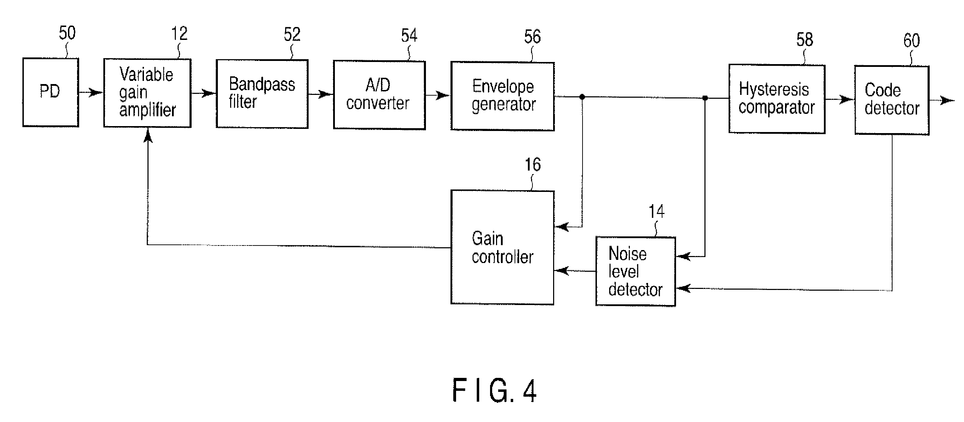

FIG. 4 shows the arrangement of an infrared signal processing device according to the fourth embodiment. FIG. 4 illustrates an example using the gain control device of a variable gain amplifier according to the third embodiment.

The infrared signal processing circuit receives an infrared remote control signal from a TV remote control transmitter (not shown). The modulation method of the remote control signal is normally the pulse position modulation (PPM) method. The PPM method distinguishes between "1" and "0" by the pulse interval. The interval of the pulse of the remote control signal comprises control codes of, for example, power on/off and channel switching. Each pulse string is amplitude modulated by the subcarrier. The subcarrier frequency of a TV remote controller is normally 38 kHz.

A photodiode (PD) 50 is connected to the input side of the variable gain amplifier 12. The photodiode 50 is a semiconductor photodiode which receives an infrared remote control signal and converts it into a current. The output signal from the variable gain amplifier 12 is input to a band pass filter 52. The center frequency of the pass band of the band pass filter 52 matches the subcarrier frequency to eliminate the influence of extraneous light and extract only the signal component.

The output from the band pass filter 52 is input to an envelope generator 56 via an analog-to-digital (A/D) converter 54. The envelope generator 56 generates an envelope from the carrier signal. The output from the envelope generator 56 is input to the gain controller 16, the noise level detector 14, and a hysteresis comparator 58.

The hysteresis comparator 58 compares the output from the envelope generator 56 with a threshold to binarize the envelope, thereby reproducing the remote control signal. The noise level detector 14 comprises a low pass filter (integrator) which detects the continuous noise level contained in the output from the envelope generator 56. The cutoff frequency of the low pass filter of the noise level detector 14 is set to be low so as to detect only noise without being affected by the remote control signal. The gain controller 16 controls the gain of the variable gain amplifier 12 such that the remote control signal level becomes a first predetermined level, and the output level of the noise level detector 14 becomes a second predetermined level as well.

The variable gain amplifier 12 converts the current output from the photodiode 50 into a voltage and amplifies it. In general, the variable gain amplifier 12 of the remote control signal reception circuit needs a dynamic range of about 100 dB. To reduce the gain error caused by variations between products, the open loop gain of the operational amplifier included in the variable gain amplifier 12 needs to be sufficiently large. However, various problems of analog circuits are recently coming to the surface, including a drop of the power supply voltage and an increase in variations between products caused by device microfabrication, resulting in difficulty in ensuring a sufficient open loop gain. When the open loop gain of the variable gain amplifier 12 decreases, the gain error increases.

The variable gain amplifier 12 amplifies and outputs both light noise disturbance input from an external device such as an inverter fluorescent lamp and noise generated by the variable gain amplifier 12 itself. The noise level of the output signal depends on the gain. Hence, even without light noise disturbance of an inverter fluorescent lamp or the like, detecting the noise level based on noise generated by the variable gain amplifier 12 itself enables to detect the gain of the variable gain amplifier 12 and adjust the gain based on the detection result.

When continuous light noise disturbance from an inverter fluorescent lamp or the like is input, gain control is done by detecting the noise level including the light noise disturbance. Hence, stable operation is possible even if light noise disturbance is input. The output signal of the hysteresis comparator 58 is input to a code detector 60. The code detector 60 determines whether the remote control signal has been detected and is equivalent to the desired signal detector 30 of the second or third embodiment. When the code detector 60 detects reception of the remote control signal, the operation of the noise level detector 14 is turned off (stopped). When detection of the remote control signal stops, the operation of the noise level detector 14 is turned on (resumed). The remote control signal detected by the code detector 60 is supplied to a control circuit (not shown) on the succeeding stage to perform various kinds of control, power on/off, channel switching, sound level change, and the like according to the remote control signal. This allows the time constant of the noise level detector 14 to be made smaller, as in the second embodiment.

In the fourth embodiment, the infrared signal processing device based on the third embodiment has been described. However, an infrared signal processing device can also be implemented based on the first or second embodiment. More specifically, the photodiode 50 is connected to the input terminal of the variable gain amplifier 12 of the first or second embodiment. In addition, the code detector 60 is connected to the output terminal of the variable gain amplifier 12 of the first embodiment or the output terminal of the desired signal detector 30 of the second embodiment.

The various modules of the systems described herein can be implemented as software applications, hardware and/or software modules, or components on one or more computers, such as servers. While the various modules are illustrated separately, they may share some or all of the same underlying logic or code.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A gain control device **characterized by** comprising:
a noise detector (14) configured to detect a noise level of a variable gain amplifier; and
a gain controller (16) configured to control a gain of the variable gain amplifier based on the noise level detected by the noise detector.

2. The device of claim 1, **characterized in that**
the gain controller (16) is configured to control the gain of the variable gain amplifier based on an output level of the variable gain amplifier.

3. The device of claim 1, **characterized in that**
a gain change range of the variable gain amplifier comprises a desired value at a center and a gain error range of each product.

4. The device of claim 1, **characterized in that**
the noise detector (16) comprises a low pass filter connected to an output terminal of the variable gain amplifier.

5. The device of claim 1, **characterized by** further comprising a signal detector (30) connected to an output terminal of the variable gain amplifier and configured to detect a desired signal, and **characterized in that**
the noise detector (14) is configured to stop an operation and to hold a detected value when the signal detector detects the desired signal.

6. The device of claim 1, **characterized by** further comprising:
an anti-aliasing filter (40) connected to an output terminal of the variable gain amplifier; and
a converter (42) connected to an output terminal of the anti-aliasing filter and configured to convert an analog signal into a digital signal, and **characterized in that**
a digital signal output from the converter is supplied to the noise detector, the gain controller, and the signal detector.

7. An infrared signal processing device **characterized by** comprising:
a receiver (50) configured to receive an infrared control signal;
a variable gain amplifier (12) connected to an output terminal of the receiver;
a filter (52) connected to an output terminal of the variable gain amplifier and configured to extract the infrared control signal;
an envelope generator (56) connected to an output terminal of the filter and configured to generate an envelope of a signal;
a noise detector (14) connected to an output terminal of the envelope generator and configured to detect a noise level of the variable gain amplifier;
a gain controller (16) configured to control a gain of the variable gain amplifier based on the noise level detected by the noise detector; and
a signal detector (60) configured to detect the infrared control signal at the output terminal of the envelope generator, and **characterized in that**
the noise detector (14) is configured to stop an operation and to hold a detected value when the signal detector (60) detects the infrared control signal.

8. A gain control method **characterized by** comprising:
detecting a noise level of a variable gain amplifier; and
controlling a gain of the variable gain amplifier based on the detected noise level.

9. The method of claim 8, **characterized in that**
the gain of the variable gain amplifier is controlled based on an output level of the variable gain amplifier.

10. The method of claim 8, **characterized in that**
a gain change range of the variable gain amplifier comprises a desired gain value at a center and a gain error range of each product.

11. The method of claim 8, **characterized in that**
the noise level is detected by a low pass filter connected to an output terminal of the variable gain amplifier.

12. The method of claim 8, **characterized by** further comprising
detecting a desired signal at an output terminal of the variable gain amplifier, and
stopping detection of the noise level and holding a detected value when the desired signal is detected.
